# EUROPEAN PATENT APPLICATION

(11) **EP 4 768 975 A1**
(43) Date of publication of application: **01.07.2026**
(21) Application number: 25827047.9
(22) Date of filing: 25.06.2025
(51) Int. Cl.: G01R 31/396, G01R 31/392, G01R 31/36, G01R 31/382, G01R 31/389, G01R 19/165, G06F 17/18

(54) **BATTERY DIAGNOSIS DEVICE AND OPERATION METHOD THEREOF**

(30) Priority: 27.06.2024 KR 20240084732
(71) Applicant: LG Energy Solution, Ltd., Seoul 07335 (KR)
(72) Inventor: LIM, Bo Mi, Daejeon 34122 (KR)
(74) Representative: BCKIP Part mbB
(86) International application number: PCT/KR2025/008893
(87) International publication number: WO 2026/005477

(57) **Abstract**

A battery diagnostic device according to an embodiment disclosed herein may include an interface configured to acquire state data including a current value and a voltage value of a battery cell for each diagnostic cycle corresponding to a charge cycle or a discharge cycle and a controller configured to calculate a similarity between current data including the current value and reference data, extract first current data having the similarity exceeding the reference value in the current data, and diagnose the battery cell for abnormalities based on a first voltage value corresponding to the first current data.

## Description

### TECHNICAL FIELD

### Cross-reference to Related Applications

This application claims priority from Korean Patent Application No. 10-2024-0084732, filed on June 27, 2024, the disclosure of which is incorporated by reference herein.

### Technical Field

Embodiments disclosed herein relates to a battery diagnostic device and a method of operating the same.

### BACKGROUND ART

In recent years, research and development for secondary batteries have been actively conducted. Here, the secondary battery is a battery capable of recharging and discharging, and in its meaning, includes all of the existing Ni/Cd battery, Ni/MH battery, and the like and a recent lithium-ion battery. Among secondary batteries, the lithium-ion battery has the advantage of a much higher energy density than the existing Ni/Cd battery, Ni/MH battery, and the like. In addition, since the lithium-ion battery may be manufactured to be small and lightweight, the lithium-ion battery is used as a power source for mobile devices, and in recent years, its scope of use has expanded to include power sources for electric vehicles, so that the lithium-ion battery attracts attention as a next-generation energy storage medium.

As the industrial fields utilizing batteries expand, a battery management system (BMS) that diagnoses the safety of batteries is also developing. The BMS may diagnose the performance of a battery utilizing various diagnostic algorithms and perform appropriate control based on the state of the battery. The BMS may diagnose the presence or absence of an abnormal battery cell. Here, "abnormality" may include all causes that may lead to ignition due to damage or aging of the battery itself.

### DISCLOSURE OF THE INVENTION

### TECHNICAL PROBLEM

By monitoring voltage values of battery cells, over voltage, under voltage, abnormal resistance, or voltage balancing between the battery cells, or the like may be diagnosed. However, there is a problem in that identifying the cause of an abnormality by monitoring the voltage values of numerous battery cells is costly and time-consuming.

The technical problems of the embodiments disclosed herein are not limited to those mentioned above, and other technical problems not mentioned will be clearly understood by those skilled in the art from the following descriptions.

### TECHNICAL SOLUTION

A battery diagnostic device according to an embodiment disclosed herein may include an interface configured to acquire state data including a current value and a voltage value of a battery cell for each diagnostic cycle corresponding to a charge cycle or a discharge cycle and a controller configured to calculate a similarity between current data including the current value and reference data, extract first current data having the similarity exceeding a reference value in the current data, and diagnose the battery cell for abnormalities based on a first voltage value corresponding to the first current data.

In an embodiment, the controller may calculate the similarity between the current data and the reference data based on a cosine similarity or Pearson similarity calculation method.

In an embodiment, the reference value may be any value included in a range of 0.85 or more and 0.95 or less.

In an embodiment, the controller may be configured to calculate dQ/dV based on the first voltage value and generate voltage value-dQ/dV data, transform the voltage value-dQ/dV data into principal component data based on principal component analysis (PCA), calculate a difference value (ΔPCₙ) (PCₙ - PC₁) between a principal component value (PCₙ) included in the principal component data corresponding to an nth diagnostic cycle (n is a natural number) among first diagnostic cycles corresponding to the first current data and a principal component value (PC₁) included in the principal component data corresponding to a first diagnostic cycle, and diagnose the battery cell for abnormalities based on the difference value (ΔPCₙ) .

In an embodiment, the controller may be configured to calculate a mean (m) and a standard deviation (σ) of difference values of a plurality of battery cells for each first diagnostic cycle and diagnose the battery cell for abnormalities based on the difference value, the mean, and the standard deviation.

In an embodiment, the controller may be configured to calculate a threshold value based on the mean and the standard deviation and diagnose the battery cell for abnormalities based on the difference value and the threshold value.

In an embodiment, the controller may diagnose the battery cell as an abnormal cell when the difference value is not included in a threshold range from m-2.5σ or more to m+2.5σ or less.

A method of operating a battery diagnostic device according to an embodiment disclosed herein may include acquiring state data including a current value and a voltage value of a battery cell over time for each diagnostic cycle corresponding to a charge cycle or a discharge cycle, calculating a similarity between current data including the current value over time and reference data, extracting first current data having the similarity exceeding a reference value in the current data, and diagnosing the battery cell for abnormalities based on a first voltage value corresponding to the first current data.

In an embodiment, the calculating of the similarity may include calculating the similarity between the current data and the reference data based on a cosine similarity or Pearson similarity calculation method.

In an embodiment, the reference value may be any value included in a range of 0.85 or more and 0.95 or less.

In an embodiment, the diagnosing may include calculating dQ/dV based on the first voltage value and generate voltage value-dQ/dV data, transforming the voltage value-dQ/dV data into principal component data based on principal component analysis (PCA), calculating a difference value (ΔPCₙ) (PCₙ - PC₁) between a principal component value (PCₙ) included in the principal component data corresponding to an nth diagnostic cycle (n is a natural number) among first diagnostic cycles corresponding to the first current data and a principal component value (PC₁) included in the principal component data corresponding to a first diagnostic cycle, and diagnosing the battery cell for abnormalities based on the difference value (ΔPCₙ).

In an embodiment, the diagnosing may include calculating a mean (m) and a standard deviation (σ) of difference values of a plurality of battery cells for each first diagnostic cycle and diagnosing the battery cell for abnormalities based on the difference value, the mean, and the standard deviation.

In an embodiment, the diagnosing may include calculating a threshold value based on the mean and the standard deviation and diagnosing the battery cell for abnormalities based on the difference value and the threshold value.

In an embodiment, the diagnosing may include diagnosing the battery cell as an abnormal cell when the difference value is not included in a threshold range from m-2.5σ or more to m+2.5σ or less.

### ADVANTAGEOUS EFFECTS

A battery diagnostic device and a method of operating the same according to various embodiments disclosed herein can acquire current data including current values over time for each charge or discharge cycle for each battery cell, calculate a similarity between the current data and reference data, and diagnose the battery cell for abnormalities using the current data having the similarity greater than or equal to a specified value. Accordingly, the battery diagnostic device and the method of operating the same can diagnose the abnormality of the battery by extracting a charge or discharge cycle in which a similar current value flows, thereby preventing misdiagnosis due to a difference in voltage values that occurs by different current values, improving the diagnostic accuracy and reducing the false positive rate.

A battery diagnostic device and a method of operating the same according to various embodiments disclosed herein can distinguish between a normal battery cell and an abnormal battery cell using voltage value-dQ/dV data corresponding to a charge or discharge cycle in which the similarity exceeds a specified value.

A battery diagnostic device and a method of operating the same according to various embodiments disclosed herein can easily detect an abnormal battery cell among battery cells by transforming voltage value-dQ/dV data for each battery cell into principal component data based on a principal component having large variance in the data through principal component analysis (PCA) .

The effects of the battery diagnostic device and the method of operating the same according to the disclosure herein are not limited to the effects mentioned above, and other effects not mentioned will be clearly understood by those skilled in the art according to the disclosure herein.

### BRIEF DESCRIPTION OF THE DRAWINGS

FIG. 1 is a block diagram illustrating a battery diagnosis system according to an embodiment disclosed herein.
FIG. 2 illustrates a battery pack according to an embodiment disclosed herein.
FIGS. 3a to 3e illustrate results of calculating a similarity between voltage data of battery cells and reference data, according to an embodiment disclosed herein.
FIG. 4 illustrates a histogram showing the number of battery cells having the similarity exceeding a reference value, according to an embodiment disclosed herein.
FIG. 5 illustrates voltage value-dQ/dV data of battery cells according to an embodiment disclosed herein.
FIG. 6 illustrates diagnostic cycle-difference value data of battery cells according to an embodiment disclosed herein.
FIG. 7 is a flowchart showing a method of operating a battery diagnostic device according to an embodiment disclosed herein.
FIG. 8 is a flowchart showing detailed operations included in operation 730 disclosed in FIG. 7.
FIG. 9 illustrates a computing system that executes operations of the battery diagnostic device according to an embodiment disclosed herein.

With respect to the description of the drawings, the same or similar reference signs may be used for the same or similar elements.

### MODE FOR CARRYING OUT THE INVENTION

Hereinafter, embodiments of the present invention will be described with reference to the accompanying drawings. However, this is not intended to limit the present invention to the specific embodiments, and it is to be construed to include various modifications, equivalents, and/or alternatives of embodiments of the present invention.

It should be appreciated that embodiments of the present disclosure and the terms used therein are not intended to limit the technological features set forth herein to a particular embodiment and include various changes, equivalents, or replacements in corresponding embodiments. With regard to the description of the drawings, similar or related reference numerals may be used to refer to similar or related elements. It is to be understood that a singular form of a noun corresponding to an item may include one or more of the things, unless the relevant context clearly indicates otherwise.

As used herein, each of phrases such as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Terms such as "1st" and "2nd," "first," "second" "A." "B," "(a)," or "(b)" may be used to simply distinguish a corresponding component from another, and do not limit the components in other aspects (e.g., importance or order) unless specifically stated otherwise.

In the present specification, it is to be understood that if an element (e.g., a first element) is referred to, with or without the term "operatively" or "communicatively," as "connected to," "coupled to," or "in contact with" another element (e.g., a second element), it means that the element may be connected to the other element directly (e.g., by wire or wirelessly) or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., a compact disc read only memory and CD-ROM), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the plurality of entities may be disposed separately from other components. According to embodiments disclosed herein, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as those performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

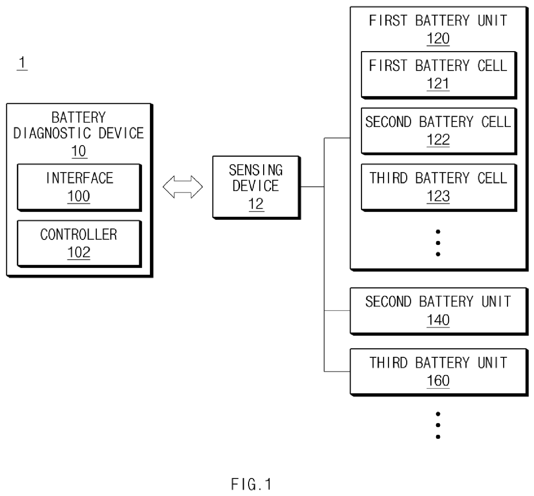

FIG. 1 is a block diagram illustrating a battery diagnosis system 1 according to an embodiment disclosed herein.

Referring to FIG. 1, the battery diagnosis system 1 may include a battery diagnostic device 10, a sensing device 12, and battery units 120, 140, and 160. Each of the battery units 120, 140, and 160 in FIG. 1 may correspond to any one of a battery rack, a battery pack, and a battery module.

The battery diagnostic device 10 may be connected to the sensing device 12 by wire and/or wirelessly.

In an embodiment, the connection between the battery diagnostic device 10 and the sensing device 12 may be a communication connection through a wired and/or wireless network. In an embodiment, the wired network may be based on local area network (LAN) communications, or power line communications. In an embodiment, the wireless network may be based on a short-range communication network (e.g., Bluetooth, wireless fidelity (WiFi), or infrared data association (IrDA)), or a long-range communication network (e.g., a cellular network, a 4G network, a 5G network).

In an embodiment, the connection between the battery diagnostic device 10 and the sensing device 12 may be a connection through a device-to-device communication method (e.g., bus, general purpose input and output (GPIO), serial peripheral interface (SPI), or mobile industry processor interface (MIPI)).

The sensing device 12 may acquire values (or information) related to the state of each of the battery units 120, 140, and 160. In an embodiment, the values related to the state may include one or more values for voltage, current, resistance, state of charge (SOC), state of health (SOH), or temperature of each of the battery units 120, 140, and 160, or a combination thereof. Each of the battery units 120, 140, and 160 may include one or more battery cells (e.g., 121, 122, 123). For example, the battery cells 121, 122, and 123 included in a first battery unit 120 may be electrically connected to each other (series and/or parallel connected). According to an embodiment, the battery cells 121, 122, and 123 may be included in the first battery unit 120 in an electrically isolated state. In FIG. 1, for convenience of description, only a first battery cell 121 to a third battery cell 123 included in the first battery unit 120 are described, but the embodiment is not limited thereto, and a second battery unit 140 and a third battery unit 160 may also include one or more battery cells.

In an embodiment, the sensing device 12 may acquire values (or information) related to the state of each of one or more battery cells 121, 122, and 123. In an embodiment, the values related to the state may include one or more values for voltage, current, resistance, state of charge (SOC), state of health (SOH), or temperature of each of the battery cells 121, 122, and 123, or a combination thereof. Hereinafter, the values related to states may be referred to as "state values."

The battery diagnostic device 10 may acquire state data including a current value and a voltage value of each of the battery cells 121, 122, and 123 from the sensing device 12. The battery diagnostic device 10 may acquire state data for each diagnostic cycle corresponding to a charge cycle or a discharge cycle. Here, the state data may include current values over time, voltage values, state of charge, state of health, temperature, or a combination thereof.

The battery diagnostic device 10 may calculate a similarity between the current values (hereinafter, current data) over time and reference data for each of the battery cells 121, 122, and 123 for each diagnostic cycle. Here, a method by which the battery diagnostic device 10 calculates the similarity may include a cosine similarity calculation method and a Pearson similarity calculation method, and the current data may include current values over time, acquired for each of one or more battery cells 121, 122, and 123 in each of one or more diagnostic cycles. In an embodiment, the reference data may be current values over time, acquired during a first charge cycle of a first battery cell 121. In an embodiment, the reference data may be data acquired through a pre-experiment, and may include current values over time, acquired during a process of charging or discharging a normal battery cell.

The battery diagnostic device 10 may extract first current data having the similarity exceeding a reference value. The battery diagnostic device 10 may extract data on the first diagnostic cycle and a battery cell corresponding to the first current data. Here, the first diagnostic cycle may include one or more charge cycles or discharge cycles of one or more battery cells. For example, when there are 30 charge cycles where the similarity exceeds the reference value among 50 charge cycles performed on the first battery cell 121, the battery diagnostic device 10 may extract the 30 charge cycles, and the 30 charge cycles may be included in the first diagnostic cycle.

The battery diagnostic device 10 may calculate dQ/dV based on the voltage values of the battery cells 121, 122, and 123 in the extracted first diagnostic cycle. The battery diagnostic device 10 may generate voltage value-dQ/dV data for each of the battery cells 121, 122, and 123 and transform the dQ/dV values according to the voltage values into principal component values through principal component analysis (PCA). The battery diagnostic device 10 may diagnose each of the battery cells 121, 122, and 123 for abnormalities based on the extracted principal components.

In an embodiment, the battery diagnostic device 10 may be included in a battery management system (BMS) capable of diagnosing battery cells included in the electronic device, and operations performed in the battery diagnostic device 10 may be performed in the BMS. In an embodiment, the battery diagnostic device 10 may be included in a server or a charge-discharge device capable of diagnosing battery cells outside the electronic device, and operations performed in the battery diagnostic device 10 may be performed in an external server or a charge-discharge device.

Hereinafter, for convenience of description, the operations performed by each of the components included in the battery diagnostic device 10 to diagnose the first battery cell 121 for abnormalities will be described.

The battery diagnostic device 10 may include an interface 100 and one or more controllers 102. According to the embodiment, the battery diagnostic device 10 illustrated in FIG. 1 may further include at least one component (e.g., a display, an input device, or an output device) other than the components illustrated in FIG. 1.

An interface 100 may acquire state data including current values and voltage values of battery cells for each diagnostic cycle corresponding to a charge or discharge cycle. The interface 100 may acquire state data including the current values and voltage values of the first battery cell 121 for each diagnostic cycle. The interface 100 may acquire current values (hereinafter, current data) of the first battery cell 121 over time for each diagnostic cycle, and may acquire voltage values of the first battery cell 121 over time. Hereinafter, for convenience of description, assuming that the diagnostic cycle is a charge cycle and that the battery diagnostic device 10 diagnoses the first battery cell 121 for abnormalities, the following description will be made.

The controller 102 may calculate the similarity between the current data including current values and the reference data. Here, the current data may include one or more current values over time, acquired for one or more battery cells in each of one or more diagnostic cycles. For example, the current data may include current values over time, acquired for each of the battery cells 121, 122, and 123 in each of 50 charge cycles when charging is performed on the battery cells 121, 122, and 123 over the 50 charge cycles.

In an embodiment, the controller 102 may calculate the similarity between the current data and the reference data based on the cosine similarity or Pearson similarity calculation method.

The controller 102 may determine whether the similarity satisfies a specified condition. Here, the specified condition may include a condition regarding whether the similarity exceeds a reference value. The similarity may be calculated as a value greater than or equal to 0 and less than or equal to 1, and the closer the similarity is to 1, the higher the similarity between the data may indicate. The reference value may be arbitrarily set by a setter, and may be set based on specified classification items. For example, the specified classification items may include poor (less than or equal to 0.000), slight (0.000 to 0.200), fair (0.201 to 0.400), moderate (0.401 to 0.600), substantial (0.601 to 0.800), and almost perfect (0.801 to 1.000), and the reference value may be set to 0.85 or 0.95. The reason why the controller 102 extracts the first current data exceeding the reference value is that only data with similar current flows is extracted, and accordingly, an abnormal battery cell in which the amount of change in voltage value is different may be easily detected even though the current flows are similar.

The controller 102 may extract the first current data having the similarity exceeding the reference value in the current data. Here, the first current data may include one or more current values over time having the similarity exceeding the reference value, among one or more current values over time included in the current data. In addition, the first current data may be a term referring not only to the first current data for the first battery cell 121, but also collectively to the first current data for each of the plurality of battery cells 121, 122, and 123.

The controller 102 may generate the voltage value-dQ/dV data by calculating dQ/dV based on a first voltage value corresponding to the first current data. The controller 102 may calculate dQ/dV based on the first voltage value acquired for each of the current values over time included in the first current data in a diagnostic cycle (a first diagnostic cycle). The controller 102 may calculate dQ/dV based on the first voltage value corresponding to the first current data among the voltage values of the first battery cell 121 acquired for each charge cycle, and may generate the voltage value-dQ/dV data based on the first voltage value. Here, the dQ/dV value may refer to a value obtained by differentiating a capacity (Q) of the first battery cell 121 by a voltage (V). The first voltage value may refer to one or more voltage values acquired in the same diagnostic cycle (hereinafter, "first diagnostic cycle") as each of one or more diagnostic cycles corresponding to the first current data.

The diagnostic cycle mentioned in FIG. 1 below is described on the premise that it is a diagnostic cycle corresponding to the first current data.

The controller 102 may transform the voltage value-dQ/dV data into principal component data based on principal component analysis (PCA). Here, the principal component analysis may be a technique for transforming high-dimensional original data into low-dimensional data based on key variables or extracting key variables for monitoring the characteristics of original data. For example, in the case where the original data is two-dimensional, when two coordinate axes corresponding to the variables with the highest variance among the values included in the original data are extracted and the original data is transformed based on the corresponding axes, the boundaries between the transformed values may become clear. That is, on the original data (e.g., the voltage value-dQ/dV data), a coordinate axis may be extracted based on a variable (e.g., a first principal component) that maximizes the variances of values (e.g., dQ/dV values and/or first voltage values) included in the original data and the two-dimensional original data may be transformed into one-dimensional data corresponding to the first principal component based on the new coordinate axis, or the two-dimensional original data may be transformed into the two-dimensional data based on first and second principal components based on a first axis corresponding to the first principal component and a second axis corresponding to the second principal component with at least one of the dQ/dV values and/or voltage values having the maximum variance, among axes orthogonal to the first axis. Since the boundaries between the transformed values included in the principal component data may become clear by the controller 102 transforming the voltage value-dQ/dV data into the principal component data, abnormal cells among the battery cells may be easily detected. Specifically, it may be easier to identify abnormal trends since the transformed data (principal component data) may have a larger variance than the original data (voltage value-dQ/dV data).

In an embodiment, the controller 102 may transform the voltage value-dQ/dV data into the principal component data for each specified voltage interval. Here, the unit of the specified voltage interval may be 0.1 V. For example, the controller 102 may transform the dQ/dV values in the voltage interval in which the voltage value is from 3.7 V to 3.8 V from the voltage value-dQ/dV data generated in the first charge cycle for the first battery cell 121 into principal component values. The reason for transforming the voltage value-dQ/dV data into principal component data for each specified voltage interval is that the principal component with the highest variance of dQ/dV values across the entire voltage interval may differ from the principal component with the highest variance for each voltage interval. Accordingly, the battery diagnostic device 10 may diagnose in detail the presence or absence of an abnormal cell showing a different tendency from normal cells in a specific voltage interval by securing the principal component data for each specific voltage interval, even when no abnormal cell is detected in the principal component data for the entire voltage interval.

The controller 102 may extract the first diagnostic cycle corresponding to the first current data, and may calculate a difference value ΔPCₙ (PCₙ - PC₁) between the principal component value PCₙ corresponding to an nth diagnostic cycle (n is a natural number) included in the first diagnostic cycle and the principal component value PC₁ corresponding to the first diagnostic cycle. For example, the controller 102 may transform the voltage value-dQ/dV data generated in a fifth diagnostic cycle included in the first diagnostic cycle for the first battery cell 121 into the principal component data, and calculate a difference value ΔPC₅ between a principal component value PC₅ included in the principal component data in the fifth charge cycle and the principal component value PC₁ in the first diagnostic cycle included in the first diagnostic cycle.

In an embodiment, the controller 102 may calculate the difference value between the principal component value PCₙ corresponding to the nth diagnostic cycle and the principal component value PC₁ corresponding to the first diagnostic cycle for each specified voltage interval. For example, the controller 102 may transform the voltage value-dQ/dV data into the principal component data based on the dQ/dV value corresponding to a voltage interval in which the voltage value is from 3.7 V to 3.8 V, and calculate the difference value ΔPC₅ between a principal component value (PC₅) in the fifth charge cycle included in the principal component data and the principal component value PC₁ in the first charge cycle. Likewise, the controller 102 may calculate the difference value in the manner described above even in other voltage intervals (e.g., 3.8 V to 3.9 V) having a different voltage value.

The controller 102 may diagnose the first battery cell 121 for abnormalities based on the difference value ΔPCₙ. Here, the abnormality may include over voltage, under voltage, resistance abnormality, or a combination thereof. In an embodiment, the controller 102 may diagnose the first battery cell 121 for abnormalities based on whether the difference value falls within a threshold range. Here, the threshold range may be calculated based on a mean m and a standard deviation σ of the difference values ΔPCₙ for each of the battery cells 121, 122, and 123. For example, the threshold range may include a range greater than or equal to a threshold minimum value (m-2.5σ) and less than or equal to a threshold maximum value (m+2.5σ). In the above, the threshold range has been described on the premise that the threshold range is a range greater than or equal to m-2.5σ and less than or equal to m+2.5σ, but this is for convenience of description, and the threshold minimum and maximum values of the threshold range are not limited thereto. In another embodiment, the controller 102 may diagnose the first battery cell 121 for abnormalities based on the relationship between the difference value and the threshold value. Here, the threshold value may be calculated based on the mean m and the standard deviation σ of the difference values ΔPCₙ of each of the battery cells 121, 122, and 123.

In an embodiment, the controller 102 may diagnose the first battery cell 121 for abnormalities for each specified voltage interval. The controller 102 may calculate the mean and the standard deviation of the difference values for each specified voltage interval. For example, the controller 102 may transform the voltage value-dQ/dV data for each of the battery cells 121, 122, and 123 into the principal component data based on the voltage interval in which the voltage value is from 3.7 V to 3.8 V in the nth charge cycle, calculate the difference value ΔPCₙ for each of the battery cells 121, 122, and 123 based on the principal component values included in the principal component data, and calculate the mean and the standard deviation accordingly. The controller 102 may diagnose the first battery cell 121 for abnormalities based on the mean and standard deviation calculated for each specified voltage interval.

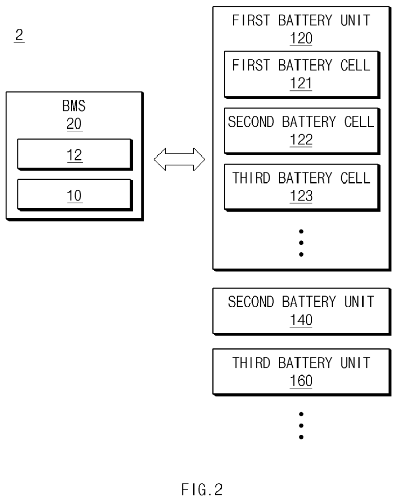

FIG. 2 illustrates a battery pack according to an embodiment disclosed herein.

Referring to FIG. 2, a battery pack 2 may be included in an electronic device. Here, the electronic device may be a mobile device (e.g., a mobile phone, a laptop computer, a smartphone, or a smart pad), an electric vehicle (e.g., an electric vehicle (EV), a hybrid EV (HEV), a plug-in HEV (PHEV), a fuel cell EV (FCEV)), an energy storage system (ESS), or a battery swapping system (BSS).

The battery pack 2 may include a BMS 20 and battery units 120, 140, and 160. Each of the battery units 120, 140, and 160 illustrated in FIG. 2 may correspond to a battery module. The BMS 20 may diagnose states of battery units 120, 140, and 160 and battery cells included therein. The BMS 20 may include the battery diagnostic device 10 and the sensing device 12 to diagnose the states of battery units 120, 140, and 160 and battery cells included therein.

The sensing device 12 may acquire a state value of each of the battery units 120, 140, and 160 included in the battery pack 2 and/or the battery cells included therein.

The battery diagnostic device 10 may diagnose, for abnormalities, each of the battery units 120, 140, and 160 and/or the battery cells included therein based on the state value acquired by the sensing device 12. In an embodiment, the battery diagnostic device 10 may be a processor (not illustrated) of the BMS 20 or may be a device included in the processor (not illustrated). In an embodiment, operations performed in the battery diagnostic device 10 may be executed by a processor (not illustrated) of the BMS 20 as one diagnostic algorithm.

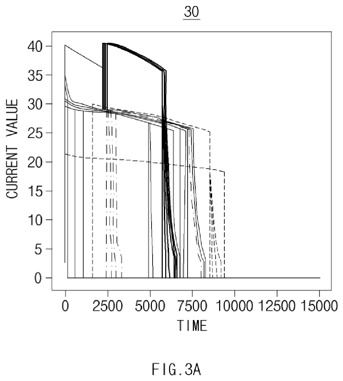

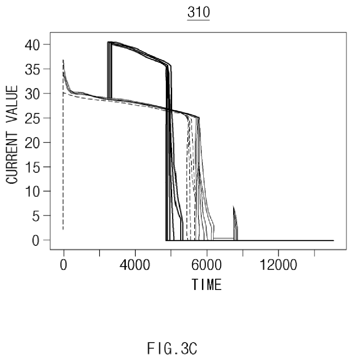

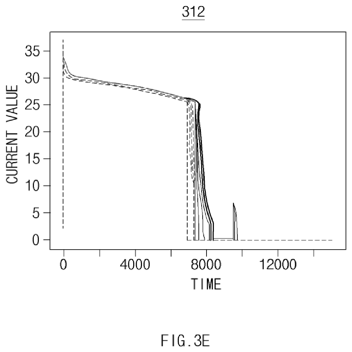

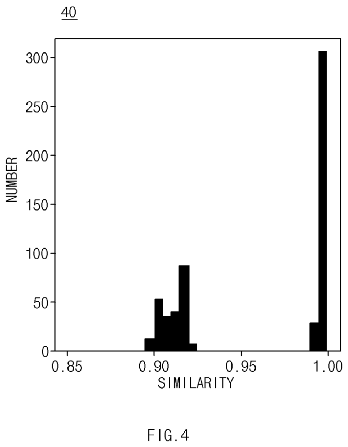

FIGS. 3a to 3e illustrate results of calculating the similarity between voltage data of battery cells and reference data, according to an embodiment disclosed herein. FIG. 4 illustrates a histogram showing the number of battery cells having the similarity exceeding a reference value, according to an embodiment disclosed herein. Hereinafter, a method of calculating the similarity between current data and reference data and extracting the first diagnostic cycle in which the similarity exceeds a specified value will be described with reference to FIGS. 3a to 3e and FIG. 4.

Referring to FIGS. 3a to 3e, the battery diagnostic device 10 may acquire current data 30 including current values over time for each diagnostic cycle. The current data 30 may include current values over time, acquired for each of the battery cells 121, 122, and 123 for each diagnostic cycle. Graphs included in the current data 30 may correspond to the nth battery cell in the nth diagnostic cycle (n is a natural number), respectively.

The battery diagnostic device 10 may calculate the similarity between the current values over time included in the current data 30 and the reference data. The battery diagnostic device 10 may extract first current data having the similarity exceeding the reference value. Here, the first current data may correspond to first data 300 to fourth data 312 depending on the similarity calculation method and/or the reference value.

The first data 300 may correspond to the first current data having a reference value exceeding 0.85 based on the cosine similarity calculation method. The second data 302 may correspond to the first current data having the reference value exceeding 0.95 based on the cosine similarity calculation method. The third data 310 may correspond to the first current data having a reference value exceeding 0.85 based on the Pearson similarity calculation method. The fourth data 312 may correspond to the first current data having the reference value exceeding 0.95 based on the Pearson similarity calculation method.

The current data 30 may include current values over time for 577 battery cells. The first data 300 may include current data for 570 battery cells having a cosine similarity exceeding 0.85 among 577 battery cells. The second data 302 may include current data for 337 battery cells having the cosine similarity exceeding 0.95 among 577 battery cells. The third data 310 may include current data for 569 battery cells having a Pearson similarity exceeding 0.85 among 577 battery cells. The fourth data 312 may include 337 battery cells having the Pearson similarity exceeding 0.95 among 577 battery cells. Referring to the first data 300 to the fourth data 312, it may be confirmed that the extracted first current data varies depending on the similarity calculation method and/or the reference value.

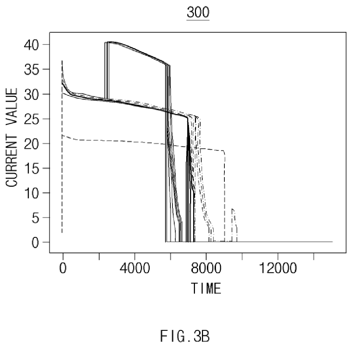

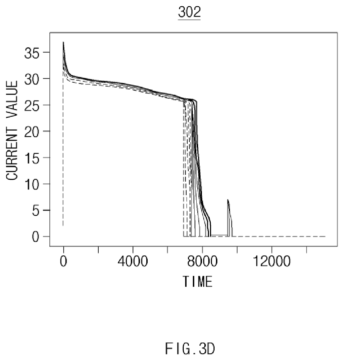

Referring to FIG. 4, a histogram 40 is a chart corresponding to the first data 300 in FIG. 3b and the second data 302 in FIG. 3d, and through the histogram 40, the number of battery cells (570 battery cells) having the cosine similarity exceeding 0.85 and the number of battery cells (337 battery cells) having the cosine similarity exceeding 0.95 may be confirmed.

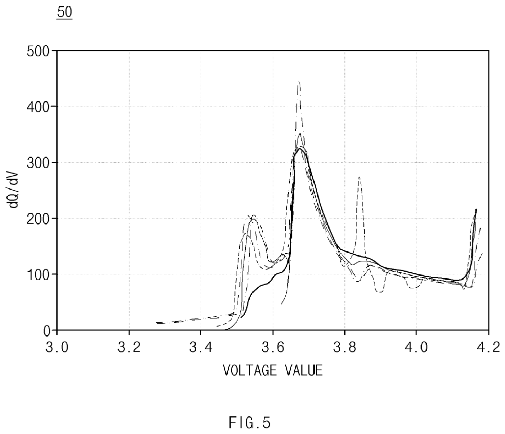

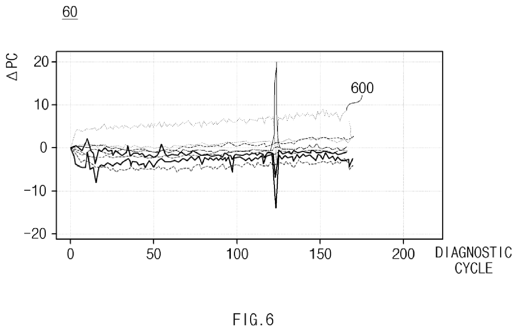

FIG. 5 illustrates voltage value-dQ/dV data of battery cells according to an embodiment disclosed herein. FIG. 6 illustrates diagnostic cycle-difference value data of battery cells according to an embodiment disclosed herein. Hereinafter, the effect according to principal component analysis will be described with reference to FIGS. 5 and 6.

Hereinafter, for convenience of description, the battery diagnostic device 10 is described on the premise that it diagnoses the first battery cell 121 based on the first current data extracted through FIGS. 3a to 3e and FIG. 4, and voltage value-dQ/dV data 50 of the battery cells is described as fifth data 50, and the diagnostic cycle-difference value data 60 of the battery cells is referred to as sixth data 60.

Referring to FIG. 5, the fifth data 50 may include graphs corresponding to voltage values of each of the battery cells 121, 122, and 123 included in the first battery unit 120 and the dQ/dV values thereof.

Referring to FIG. 6, the sixth data 60 may include principal component data for each of the battery cells 121, 122, and 123 included in the first battery unit 120. The sixth data 60 may include graphs corresponding to difference values according to diagnostic cycles for each of the battery cells 121, 122, and 123 included in the first battery unit 120. For example, when the number of diagnostic cycles that have been finally performed is 150, the sixth data 60 may include a difference value (ΔPC₁ = 0) corresponding to the principal component value PC₁ in the first diagnostic cycle to a difference value ΔPC₁₅₀ between a principal component value PC₁₅₀ in the 150th diagnostic cycle and the principal component value PC₁ in the first diagnostic cycle for each of the battery cells 121, 122, and 123.

In an embodiment, the sixth data 60 may include graphs corresponding to difference values according to diagnostic cycles for each of the battery cells 121, 122, and 123 in a specified voltage interval (3.7 V to 3.8 V). Hereinafter, the sixth data 60 is described on the premise that the sixth data 60 is data including difference values according to diagnostic cycles for each of the battery cells 121, 122, and 123 in the specified voltage interval (3.7 V to 3.8 V).

The fifth data 50 in FIG. 5 may correspond to the original data before principal component analysis, and the sixth data 60 in FIG. 6 may correspond to the principal component data transformed from the original data. While the fifth data 50 has unclear boundaries of dQ/dV values of each of the battery cells 121, 122, and 123, the sixth data 60 is data obtained by transforming the fifth data 50 through extraction of principal components having large variance among data in a specified voltage interval, and it can be confirmed that the boundaries of data among the battery cells 121, 122, and 123 become clear.

Based on the aforementioned content, the battery diagnostic device 10 may diagnose the first battery cell 121 for abnormalities based on the sixth data 60. For example, referring to a graph 600 for the first battery cell 121, the battery diagnostic device 10 may diagnose the difference value of the first battery cell 121 as not being included in the threshold range.

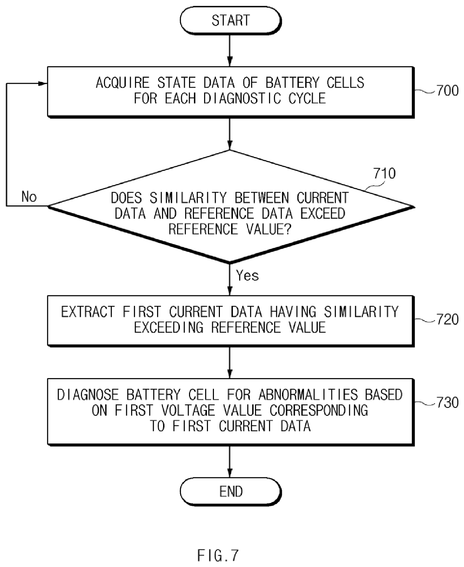

FIG. 7 is a flowchart showing a method of operating a battery diagnostic device according to an embodiment disclosed herein.

Referring to FIG. 7, in operation 700, the battery diagnostic device 10 may acquire state data including current values and voltage values of battery cells for each diagnostic cycle corresponding to a charge or discharge cycle. The battery diagnostic device 10 may acquire state data including the current values and voltage values of the first battery cell 121 for each diagnostic cycle. The battery diagnostic device 10 may acquire current values (current data) of the first battery cell 121 over time for each diagnostic cycle, and may acquire voltage values of the first battery cell 121 over time.

In operation 710, the battery diagnostic device 10 may calculate the similarity between current data and reference data. The battery diagnostic device 10 may determine whether the similarity between current data and reference data satisfies a specified condition. Here, the specified condition may include a condition regarding whether the similarity exceeds a reference value.

When the similarity between the current data and the reference data does not satisfy the specified condition (NO), the battery diagnostic device 10 may return to operation 700 and acquire state data of the battery cells based on a new diagnostic cycle.

When the similarity between the current data and the reference data satisfies the specified condition (YES), the battery diagnostic device 10 may perform operation 720 using current data (first current data) that satisfies the specified condition.

In operation 720, the battery diagnostic device 10 may extract first current data having the similarity exceeding the reference value.

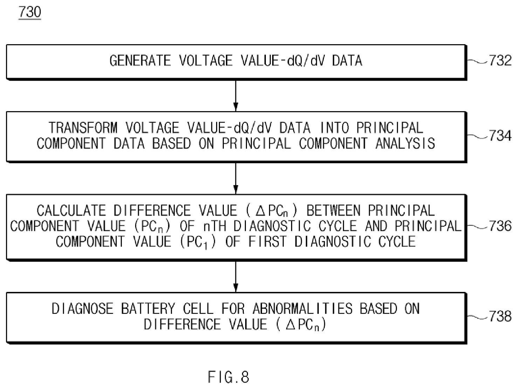

In operation 730, the battery diagnostic device 10 may diagnose the battery cell for abnormalities based on the first voltage value corresponding to the first current data. The detailed operations of operation 730 are described in detail in FIG. 8 below.

FIG. 8 is a flowchart showing detailed operations included in operation 730 disclosed in FIG. 7.

Referring to FIG. 8, operations 732 to 738 may be included in operation 730 in FIG. 7. The diagnostic cycle mentioned in FIG. 8 below is described on the premise that it is a diagnostic cycle corresponding to the first current data extracted in operation 710 of FIG. 7.

In operation 732, the battery diagnostic device 10 may generate voltage value-dQ/dV data by calculating dQ/dV based on the first voltage value corresponding to the first current data. The controller 102 may calculate dQ/dV based on the first voltage value corresponding to the first current data among the voltage values of the first battery cell 121 acquired for each charge cycle, and may generate the voltage value-dQ/dV data based on the first voltage value.

In operation 734, the battery diagnostic device 10 may transform the voltage value-dQ/dV data into principal component data based on principal component analysis (PCA).

In an embodiment, the battery diagnostic device 10 may transform the voltage value-dQ/dV data into the principal component data for each specified voltage interval.

In operation 736, the battery diagnostic device 10 may calculate the difference value ΔPCₙ (PCₙ - PC₁) between the principal component value PCₙ corresponding to the nth diagnostic cycle (n is a natural number) and the principal component value (PC₁) corresponding to the first diagnostic cycle.

In an embodiment, the battery diagnostic device 10 may calculate the difference value between the principal component value PCₙ corresponding to the nth diagnostic cycle and the principal component value PC₁ corresponding to the first diagnostic cycle for each specified voltage interval.

In operation 738, the battery diagnostic device 10 may diagnose the first battery cell 121 for abnormalities based on the difference value ΔPCₙ. In an embodiment, the battery diagnostic device 10 may diagnose the first battery cell 121 for abnormalities based on whether the difference value falls within a threshold range. Here, the threshold range may be calculated based on a mean m and a standard deviation σ of the difference values ΔPCₙ for each of the battery cells 121, 122, and 123. For example, the threshold range may include a range greater than or equal to a threshold minimum value (m-2.5σ) and less than or equal to a threshold maximum value (m+2.5σ). In another embodiment, the battery diagnostic device 10 may diagnose the first battery cell 121 for abnormalities based on the relationship between the difference value and the threshold value. Here, the threshold value may be calculated based on the mean m and the standard deviation σ of the difference values ΔPCₙ of each of the battery cells 121, 122, and 123.

In an embodiment, the battery diagnostic device 10 may diagnose the first battery cell 121 for abnormalities for each specified voltage interval. The battery diagnostic device 10 may calculate the mean and the standard deviation of the difference values for each specified voltage interval. The battery diagnostic device 10 may diagnose the first battery cell 121 for abnormalities based on the mean and standard deviation calculated for each specified voltage interval.

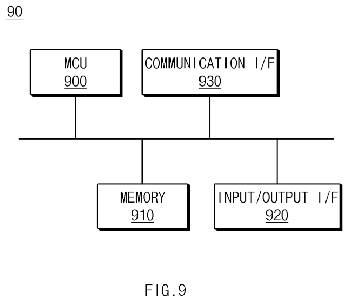

FIG. 9 illustrates a computing system that executes operations of the battery diagnostic device according to an embodiment disclosed herein.

Referring to FIG. 9, a computing system 90 according to an embodiment disclosed herein may include a microcontroller unit (MCU) 900, a memory 910, an input/output interface (I/F) 920, and a communication I/F 930.

The MCU 900 may be a processor that executes various programs (e.g., a battery diagnosis program) stored in the memory 910, processes various data from the programs, and performs functions of the battery diagnostic device 10 illustrated in FIGS. 1 to 8 described above.

The memory 910 may store various programs related to the operations of the battery diagnostic device 10. addition, the memory 910 may store operating data of the battery diagnostic device 10.

A plurality of memories 910 may be provided as needed. The memory 910 may be a volatile memory or non-volatile memory. As the volatile memory, the memory 910 may be a random access memory (RAM), dynamic RAM (DRAM), static RAM (SRAM), or the like. As the non-volatile memory, for the memory 910, a read-only memory (ROM), a programmable ROM (PROM), an electrically alterable ROM (EAROM), an erasable programmable ROM (EPROM), an electrically erasable programmable ROM (EEPROM), a flash memory, or the like may be used. The memories 910 listed above are only exemplary and are not limited to the examples.

The input/output I/F 920 may provide an interface that connects an input device (not illustrated) such as a keyboard, a mouse, a touch panel, or the like, and an output device such as a display (not illustrated), to the MCU 600 to enable data transmission and reception.

The communication I/F 930 is a component that may transmit and receive various data to and from the server, and may be any device that may support wired or wireless communication. For example, a program for abnormal diagnosis or various data (e.g., state values) may be transmitted to and received from a separately provided external server through the communication I/F 930.

Terms such as "include," "comprise," or "have" described above mean that the corresponding component may be present unless otherwise stated, and thus it should be construed that other components may be further included rather than excluding other components. All terms including technical or scientific terms have the same meaning as commonly understood by those of ordinary skill in the art to which embodiments disclosed herein belong, unless otherwise defined. Terms commonly used such as those defined in dictionaries should be interpreted as having a meaning that is consistent with their meaning in the context of the related art and will not be interpreted in an idealized or overly formal sense unless expressly so defined herein.

The above description is merely an example of the technical idea disclosed herein, and those with ordinary skill in the art to which the embodiments disclosed herein belong may make various modifications and variations without departing from the essential characteristics of the embodiments disclosed herein. Accordingly, the embodiments disclosed herein are not intended to limit the technical ideas of the embodiments disclosed herein but rather to explain them, and the scope of the technical ideas disclosed herein is not limited by these embodiments. The scope of protection disclosed herein should be interpreted by the accompanying claims, and all technical ideas within the scope equivalent thereto should be construed as being included in the scope of rights herein.

## Claims

1. A battery diagnostic device comprising:
an interface configured to acquire state data including a current value and a voltage value of a battery cell for each diagnostic cycle corresponding to a charge cycle or a discharge cycle; and
a controller configured to:
calculate a similarity between current data including the current value and reference data;
extract first current data having the similarity exceeding a reference value in the current data; and
diagnose the battery cell for abnormalities based on a first voltage value corresponding to the first current data.

2. The battery diagnostic device of claim 1, wherein the controller calculates the similarity between the current data and the reference data based on a cosine similarity or Pearson similarity calculation method.

3. The battery diagnostic device of claim 1, wherein the reference value is any value included in a range of 0.85 or more and 0.95 or less.

4. The battery diagnostic device of claim 1, wherein the controller is configured to:
calculate dQ/dV based on the first voltage value and generate voltage value-dQ/dV data;
transform the voltage value-dQ/dV data into principal component data based on principal component analysis (PCA);
calculate a difference value (ΔPCₙ) (PCₙ - PC₁) between a principal component value (PCₙ) included in the principal component data corresponding to an nth diagnostic cycle (n is a natural number) among first diagnostic cycles corresponding to the first current data and a principal component value (PC₁) included in the principal component data corresponding to a first diagnostic cycle; and
diagnose the battery cell for abnormalities based on the difference value (ΔPCₙ).

5. The battery diagnostic device of claim 4, wherein the controller is configured to:
calculate a mean (m) and a standard deviation (σ) of difference values of a plurality of battery cells for each first diagnostic cycle; and
diagnose the battery cell for abnormalities based on the difference value, the mean, and the standard deviation.

6. The battery diagnostic device of claim 5, wherein the controller is configured to:
calculate a threshold value based on the mean and the standard deviation; and
diagnose the battery cell for abnormalities based on the difference value and the threshold value.

7. The battery diagnostic device of claim 5, wherein the controller diagnoses the battery cell as an abnormal cell when the difference value is not included in a threshold range from m-2.5σ or more to m+2.5σ or less.

8. A method of operating a battery diagnostic device, comprising:
acquiring state data including a current value and a voltage value of a battery cell over time for each diagnostic cycle corresponding to a charge cycle or a discharge cycle;
calculating a similarity between current data including the current value over time and reference data;
extracting first current data having the similarity exceeding a reference value in the current data; and
diagnosing the battery cell for abnormalities based on a first voltage value corresponding to the first current data.

9. The method of claim 8, wherein the calculating of the similarity includes calculating the similarity between the current data and the reference data based on a cosine similarity or Pearson similarity calculation method.

10. The method of claim 8, wherein the reference value is any value included in a range of 0.85 or more and 0.95 or less.

11. The method of claim 8, wherein the diagnosing includes:
calculating dQ/dV based on the first voltage value and generate voltage value-dQ/dV data;
transforming the voltage value-dQ/dV data into principal component data based on principal component analysis (PCA);
calculating a difference value (ΔPCₙ) (PCₙ - PC₁) between a principal component value (PCₙ) included in the principal component data corresponding to an nth diagnostic cycle (n is a natural number) among first diagnostic cycles corresponding to the first current data and a principal component value (PC₁) included in the principal component data corresponding to a first diagnostic cycle; and
diagnosing the battery cell for abnormalities based on the difference value (ΔPCₙ).

12. The method of claim 11, wherein the diagnosing includes:
calculating a mean (m) and a standard deviation (σ) of difference values of a plurality of battery cells for each first diagnostic cycle; and
diagnosing the battery cell for abnormalities based on the difference value, the mean, and the standard deviation.

13. The method of claim 12, wherein the diagnosing includes:
calculating a threshold value based on the mean and the standard deviation; and
diagnosing the battery cell for abnormalities based on the difference value and the threshold value.

14. The method of claim 12, wherein the diagnosing includes diagnosing the battery cell as an abnormal cell when the difference value is not included in a threshold range from m-2.5σ or more to m+2.5σ or less.
